# EUROPEAN PATENT SPECIFICATION

(11) **EP 3 534 537 B1**
(45) Date of publication and mention of the grant of the patent: **04.11.2026**
(21) Application number: 17866024.7
(22) Date of filing: 30.06.2017
(51) Int. Cl.: H03F 1/26, H03F 3/189, H03F 1/32, H03F 3/195, H03F 3/24, H03F 1/56

(54) **RADIO FREQUENCY POWER AMPLIFIER FOR INHIBITING HARMONIC WAVE AND STRAY, CHIP AND COMMUNICATION TERMINAL**
HOCHFREQUENZLEISTUNGSVERSTÄRKER ZUR HEMMUNG VON HARMONISCHEN WELLEN UND STREUVERLUST, CHIP UND KOMMUNIKATIONSENDGERÄT
AMPLIFICATEUR DE PUISSANCE RADIOFRÉQUENCE PERMETTANT L'INHIBITION D'ONDE HARMONIQUE ET DE DISPERSION, PUCE ET TERMINAL DE COMMUNICATION

(30) Priority: 31.10.2016 CN 201610927929
(43) Date of publication of application: 04.09.2019
(73) Proprietor: Vanchip (Tianjin) Technology Co., Ltd., Tianjin 300457 (CN)
(72) Inventor: ZHAO, Jinxin, Tianjin 300457 (CN); BAI, Yunfang, Tianjin 300457 (CN); LIN, Sheng, Tianjin 300457 (CN)
(74) Representative: Wang, Bo
(86) International application number: PCT/CN2017/091347
(87) International publication number: WO 2018/076766

(56) References cited:
- WO-A1-2013/188712
- WO-A1-2014/087479
- CN-A- 101 414 806
- CN-A- 102 983 823
- CN-A- 106 549 638
- CN-U- 201 616 811
- JP-A- H08 148 949
- US-A1- 2007 182 490
- US-A1- 2013 135 043
- US-A1- 2014 266 455

## Description

### BACKGROUND

### Technical Field

The present invention relates to a radio frequency power amplifier, particularly relates to a radio frequency power amplifier capable of suppressing harmonic wave and spurious, also relates to a chip including the radio frequency power amplifier and a communication terminal including the radio frequency power amplifier, and belongs to the technical field of integrated circuits.

### Related Art

With the rapid development of the wireless communication technology, the linear performance requirements for wireless transceivers are gradually increasing. A radio frequency power amplifier as the last stage in a transmitter greatly influences the linear performance of a whole transceiver. Generally, the last stage of the radio frequency power amplifier adopts a class A or class B power amplifier. Due to the influence of nonlinear distortion, when a signal is increased to a certain extent, the radio frequency power amplifier generates a series of harmonic waves and spurious because the radio frequency power amplifier works in a nonlinear region, the linear performance of the radio frequency power amplifier is greatly influenced, and thus, suppression of the harmonic wave and spurious becomes an important measure for enhancing the linearity of the radio frequency power amplifier.

The Chinese patent application with the application number of 201510057384.5 discloses a circuit structure for improving the harmonic performance of a radio frequency power amplifier. The circuit structure includes a radio frequency power amplifying tube, a second harmonic suppression network, a third harmonic suppression network, a higher harmonic suppression network, a first matching inductor, a second matching inductor and a blocking capacitor. The first matching inductor, the second matching inductor, the third harmonic suppression network and the higher harmonic suppression network form a low-pass output matching network of the power amplifier, and the low-pass output matching network is connected to a collector electrode of the power amplifying tube. The second harmonic suppression network is connected to the collector electrode of the power amplifying tube and is independent of the output matching network, and the suppression frequency is adjustable. The third harmonic suppression network and the higher harmonic suppression network are involved in the output matching network, and the higher harmonic suppression frequency is adjustable. The circuit structure effectively suppress a harmonic component generated by the radio frequency power amplifier and improves the performance of the power amplifier.

However, the radio frequency power amplifier in the transmitter also generates out-of-band spurious output, and the spurious output is positioned in a frequency band of a receiver. If the spurious output cannot be well isolated, the spurious output may be coupled to an input end of a low noise amplifier at the front end of the receiver to form interference, or may also interfere with other adjacent channels. Therefore, the radio frequency power amplifier needs to be further improved to ensure that the improved radio frequency power amplifier not only can suppress the harmonic wave but also can limit out-of-band spurious output.

Moreover, WO2013188712A1 provides a power amplifier with an output harmonic termination circuit and an output fundamental termination circuit both connecting an collector of the bipolar transistor of the power amplifier output stage, so as to prevent a portion of the power of the harmonic frequency components of the second stage amplified RF signal from being leaked toward a load.

In addition, JPH08148949A provides a high frequency amplifier, in which the serial resonane circuit resonates with the second harmonic, the parallel resonance circuit resonates with the fundamental waves and the third harmonic along with the serial resonance circuit, and a short-circuit load is realized in the second harmonic and an open load is realized in the third harmonic.

WO2014087479A1 is provided with a series resonant circuit, one end of which is connected between a high-frequency signal amplification transistor and a bias circuit, and the other end of which is connected to ground, the series resonant circuit including an inductor and a capacitor. By this configuration, noise having a differential frequency that occurs in the bias circuit is suppressed from being input to the high-frequency signal amplification transistor.

US2014266455A1 individually provides an amplifier, which can adapt to different modes and different frequency bands of operation by appropriate switching and/or tuning of the harmonic terminations and/or the variable impedance matching network.

### SUMMARY

The present invention aims to solve the first technical problem and provide a radio frequency power amplifier capable of suppressing harmonic wave and spurious.

The present invention aims to solve another technical problem and provide a chip including the radio frequency power amplifier and a communication terminal including the radio frequency power amplifier.

The invention is set out in the appended set of claims.

### BRIEF DESCRIPTION OF THE DRAWINGS

FIG. 1 is a schematic circuit diagram of a radio frequency power amplifier provided by the present invention;
FIG. 2 is a schematic diagram of a harmonic suppression unit in the radio frequency power amplifier provided by the present invention;
FIG. 3 is a schematic diagram showing connection between a spurious suppression unit and an amplifying unit in the radio frequency power amplifier provided by the present invention;
FIG. 4 is a schematic diagram showing connection between each stage of load of the spurious suppression unit and a corresponding amplifying circuit in the radio frequency power amplifier provided by the present invention;
FIG. 5 is a schematic circuit diagram of the low-pass matching network in the radio frequency power amplifier provided by the present invention; and
FIG. 6 is a schematic circuit diagram of another radio frequency power amplifier provided by the present invention.

### DETAILED DESCRIPTION

The following further describes technical contents of the present invention in details with reference to accompanying diagrams and specific embodiments.

Firstly, it should be noted that a communication terminal involved in each embodiment of the present invention refers to computer device which can be used in a mobile environment and supports multiple communication systems such as GSM, EDGE, TD_SCDMA, TDD_LTE and FDD_LTE, and the computer device includes a mobile phone, a notebook computer, a tablet computer, an on-board computer or the like. In addition, the radio frequency power amplifier is also suitable for other application occasions of power amplifying circuits, such as communication base stations compatible with various communication systems.

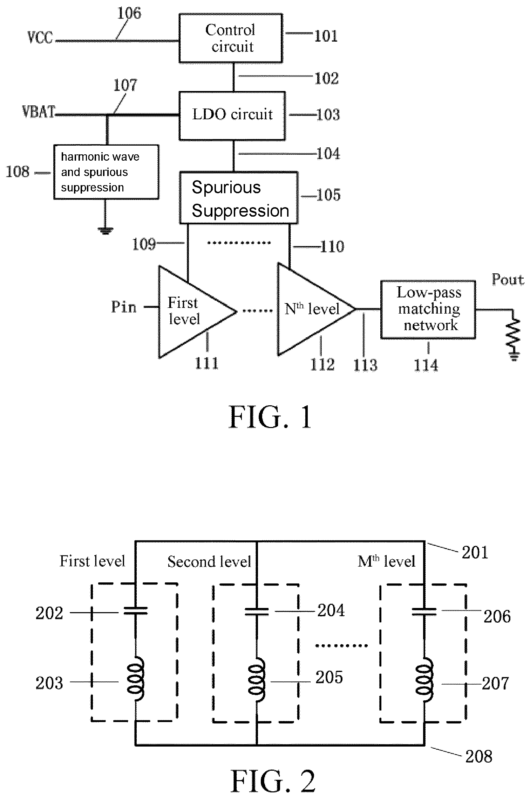

FIG. 1 is a schematic circuit diagram of a radio frequency power amplifier capable of suppressing harmonic wave and spurious provided by the present invention. As shown in FIG. 1, the radio frequency power amplifier includes a control circuit 101, an LDO (low dropout regulator) circuit 103, a spurious suppression unit 105, a harmonic suppression unit 108, an amplifying unit and a low-pass matching network 114. A first power source 106 supplies a power supply voltage for the control circuit 101 to enable the control circuit 101 to generate a control voltage 102, and the LDO circuit 103 is controlled by means of the control voltage 102 and a second power source 107, so as to output different voltages 104 according to different power stages. The harmonic suppression unit 108 is arranged between the second power source 107 and the ground, to effectively suppress harmonic wave and spurious components generated in a power supply process of the second power source 107 and supply a stable power supply voltage for the LDO circuit 103, thereby suppressing the harmonic wave and spurious components in the voltage 104 output by the LDO circuit 103. The spurious suppression unit 105 is arranged between the voltage 104 and the amplifying unit to reduce the gain of the amplifying unit at the resonance frequency, thereby reducing the output spurious (the spurious is mainly generated by the amplifying unit and is not generated by the LDO circuit). An amplified radio frequency signal is finally output to a load (such as an antenna) by means of the low-pass matching network 114. By means of the low-pass matching network 114, impedance matching can be realized, and the harmonic wave and spurious in the output radio frequency signal can also be suppressed, so that interference is avoided even if the radio frequency signal falls into a receiving frequency band of another system.

The amplifying unit is a multi-stage amplifying circuit including a plurality of amplifying circuits in cascade. As shown in FIG. 1, the multi-stage amplifying circuit comprises a first stage of amplifying circuit 111 and an N^{th} (N is a positive integer) stage of amplifying circuit 112 in cascade. In FIG. 1, for the sake of simplicity, only the first stage of amplifying circuit 111 and the last stage of amplifying circuit 112 are shown. A plurality of amplifying circuits can be arranged between the first stage of amplifying circuit 111 and the last stage of amplifying circuit 112. By respectively connecting a plurality of amplifying circuits with the spurious suppression unit 105, the spurious generated by the amplifying unit can be effectively suppressed.

In one embodiment of the present invention, the LDO circuit 103 can be any LDO capable of outputting different voltages according to different power levels. The LDO ensures that the voltage difference between ports of the transistors does not exceed a nominal voltage value of a self-process, thereby preventing the voltage difference between the ports of the transistors from exceeding a nominal withstand voltage value of the self-process along with the increase of the power voltage, so as to prevent the device from being burnt out.

FIG. 2 is a schematic circuit diagram of the harmonic suppression unit 108 in one embodiment of the radio frequency power amplifier. As shown in FIG. 2, the harmonic suppression unit 108 is an LC array which is composed of M (M is a positive integer, the same below) LC series resonance circuits connected in parallel. Each LC series resonance circuit comprises a capacitor and an inductor connected in series. Referring to a dotted line box in FIG. 2, a capacitor 202 and an inductor 203 are connected in series to form a first stage of series resonance circuit, a capacitor 204 and an inductor 205 form a second stage of series resonance circuit, and accordingly, a capacitor 206 and an inductor 207 form an M^{th} stage of series resonance circuit. The LC array can have any number of stages, and the first stage of series resonance circuit, the second stage of series resonance circuit and the N^{th} stage of series resonance circuit are connected in parallel to form the LC array. One end 201 of the harmonic suppression unit 108 of the radio frequency power amplifier is connected to the second power source 107, and the other end 208 of the harmonic suppression unit 108 is grounded. The capacitor 202 and the inductor 203 have a resonance frequency f1, the capacitor 204 and the inductor 205 have a resonance frequency f2, the capacitor 206 and the inductor 207 have a resonance frequency fM, and the earth impedance of the second power source 107 is low at the frequency f1, the frequency f2 and the frequency fM, so that the harmonic wave and spurious of the second power source 107 at the frequency f1, the frequency f2 and the frequency fM can be suppressed. The frequency f1, the frequency f2 and the frequency fM can be set to be any different frequencies (higher than the working frequency or lower than the working frequency). The harmonic suppression unit 108 is embedded between the second power source 107 and the ground to suppress the harmonic wave and spurious of the second power source in a power supply process at different resonance frequencies.

FIG. 3 is a schematic diagram showing connection between the spurious suppression unit 105 and the amplifying unit in one embodiment of the radio frequency power amplifier. As shown in the dotted line box in FIG. 3, a first stage of load (namely the load of a first stage of amplifying circuit) comprises an inductor 307, an LC array 308 and an inductor 309. One end of the LC array 308 is respectively connected to one end of the inductor 307 and one end of the inductor 309, and the other end of the LC array 308 is grounded. The inductor 309 serves as a load inductor of the first stage of amplifying circuit, and the other end of the load inductor 309 is connected to a collector electrode or a drain electrode (not shown in FIG. 3) of a transistor 312 of the first stage of amplifying circuit, so that a load function can be realized, and furthermore, the spurious can be suppressed. The inductor 307 serves as an inter-stage isolation inductor, the other end of the inductor 307 is connected to a second load, and the second load is the same as the first load. In order to simplify the description, only the first stage of load, an (N-1)^{th} stage of load and an N^{th} (N is a positive integer, the same below) of load are shown in FIG. 3. The (N-1)^{th} stage of load (the load of an (N-1)^{th} stage of amplifying circuit) comprises an inductor 304, an LC array 305 and an inductor 306. One end of the LC array 305 is respectively connected to one end of the inductor 304 and one end of the inductor 306, and the other end of the LC array 308 is grounded. The inductor 306 serves as a load inductor of the (N-1)^{th} stage of amplifying circuit, and the other end of the load inductor 306 is connected to a collector electrode or a drain electrode (not shown in FIG. 3) of a transistor 311 of the (N-1)^{th} stage of amplifying circuit, so that the load function can be realized, and furthermore, the spurious can be suppressed. The inductor 304 serves as an inter-stage isolation inductor, and the other end of the inductor 304 is connected to the N^{th} stage of load. Generally, the inductance value of the inductor 304 and the inductance value of the inductor 307 are larger so as to realize isolation of spurious. The N^{th} stage of load (namely the load of an N^{th} stage of amplifying circuit) comprises an inductor 303 and an LC array 302. One end of the LC array 302 is respectively connected to one end of the inductor 303 and a voltage source 301 (voltage 104 in FIG. 1), and the other end of the LC array 302 is grounded. The inductor 303 serves as a load inductor of the N^{th} stage of amplifying circuit, and the other end of the load inductor 303 is connected to a collector electrode or a drain electrode (not shown in FIG. 3) of a transistor 310 of the N^{th} stage of amplifying circuit, so that the load function can be realized, and furthermore, the spurious can be suppressed. In conclusion, the spurious suppression unit 105 comprises loads of N amplifying circuits in cascade, and the isolation inductor in each stage of load is connected to the next stage of load to realize isolation of spurious in the amplifying unit. Furthermore, the load inductor in each stage of load is respectively connected to the collector electrode or the drain electrode of the transistor in the corresponding amplifying circuit to realize an suppressing effect on spurious of the transistor in each stage of amplifying circuit. The voltage source 301 supplies a power supply voltage to the corresponding amplifying circuit by means of each stage of load respectively, and filters out the spurious interference to a radio frequency signal for each stage of amplifying circuit by means of the spurious suppression unit 105. The radio frequency signal is transmitted into the amplifying unit, a capacitor is arranged between every two stages of amplifying circuits of the amplifying unit, the radio frequency signal amplified by the previous stage of amplifying circuit is transmitted to the next stage of amplifying circuit by means of the capacitor, and finally, the amplified radio frequency signal is output to the outside by means of the last stage of amplifying circuit.

FIG. 4 is a schematic diagram showing connection between each stage of load of the spurious suppression unit 105 and the corresponding amplifying circuit. As shown in FIG. 4, each stage of load comprises a load inductor and an LC array 400, and every two stages of loads are connected by means of an isolation inductor. The LC array 400 comprises M (M is a positive integer, the same below) LC series resonance circuits connected in parallel, and each LC series resonance circuit comprises a capacitor and an inductor connected in series. Referring to a dotted line box in FIG. 4, a capacitor 402 and an inductor 403 are connected in series to form a first stage of series resonance circuit, a capacitor 404 and an inductor 405 form a second stage of series resonance circuit, and a capacitor 406 and an inductor 407 form an M^{th} stage of series resonance circuit. The LC array can have any number of stages, and the first stage of series resonance circuit, the second stage of series resonance circuit and the M^{th} stage of series resonance circuit are connected in parallel to form the LC array 400. One end 409 of the LC array 400 is respectively connected to one end of a load inductor 401 and one end of an isolation inductor 408, the other end 410 of the LC array 400 is grounded, the other end of the load inductor 401 is connected to a collector electrode or a drain electrode (not shown in FIG. 4) of a transistor 411 in the amplifying unit, and an emitter electrode or a source electrode of the transistor 411 is grounded. Because the isolation inductor 408 is an inter-stage isolation inductor, the isolation inductor 408 can be regarded as high impedance, the load inductor 401 and the LC array 400 generate M resonance points, and resonance frequencies corresponding to the M resonance points are respectively f1, f2, ..., and fM. The earth impedance of the transistor 411 is low at the M frequencies, thereby suppressing the spurious of the transistor 411 at the M frequencies. In order to consider the performance of a working band, the frequencies f1, f2, ..., and fM are set to be lower than the working frequency, so that the LC array 400 can be matched with the load inductor 401 to suppress the spurious at a frequency lower than the working frequency. In conclusion, the load inductor in each stage of load and the LC array generate a plurality of resonance points of which the frequencies are lower than the working frequency, and the number of the resonance points generated in each stage of load and the resonance frequencies are independent of each other, so that the spurious at different frequencies can be suppressed by means of flexible configuration.

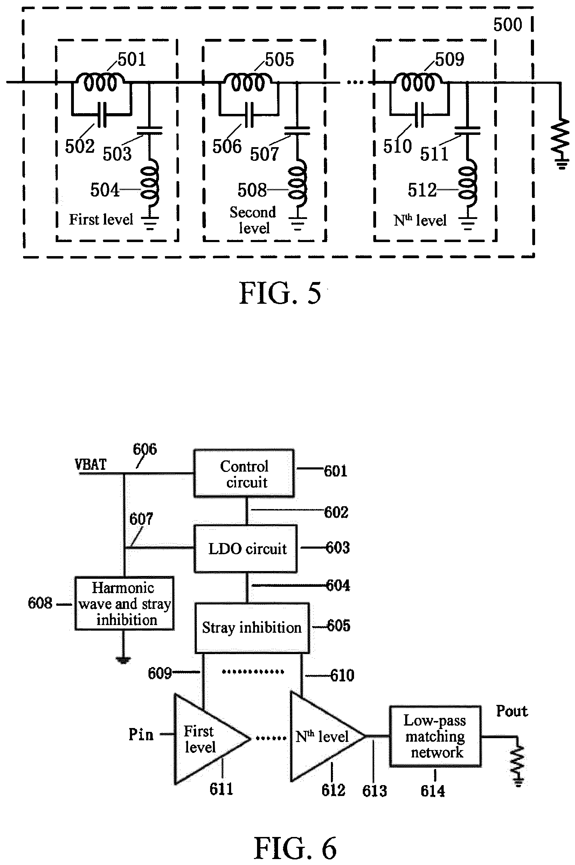

FIG. 5 is a schematic circuit diagram of the low-pass matching network in one embodiment of the radio frequency power amplifier. As shown in FIG. 5, the low-pass matching network 500 (marked 114 in FIG. 1) is a multi-stage matching network which is composed of N (N is a positive integer, the same below) matching networks in cascade. Each stage of matching network comprises a first inductor, a first capacitor, a second inductor and a second capacitor, the first inductor and the first capacitor are connected in parallel to form an LC parallel resonance circuit, the second inductor and the second capacitor are connected in series to form an LC series resonance circuit, one end of the LC series resonance circuit is connected to the LC parallel resonance circuit, and the other end of the LC series resonance circuit is grounded. In each stage of matching network, the resonance frequency f1 of the LC parallel resonance circuit is set to be higher than the working frequency, and the resonance frequency f2 of the LC series resonance circuit is set to be higher than the working frequency. In the LC parallel resonance circuit, the first inductor and the first capacitor are connected in parallel to show high impedance at the resonance frequency f1, and the harmonic wave and spurious at the resonance frequency f1 can be suppressed by means of voltage division action. In the LC series resonance circuit, the second inductor and the second capacitor are connected in series to show low earth impedance at the resonance frequency f2, and the harmonic wave and spurious at the resonance frequency f2 can be suppressed by means of current division action. In each stage of matching network, the LC parallel resonance circuit shows inductivity at the working frequency, and the LC series resonance circuit shows capacitivity at the working frequency, so that each stage of matching network is an L-C low-pass matching network at the working frequency. Specifically, as shown in FIG. 5, an inductor 501, an inductor 502, a capacitor 503 and an inductor 504 form a first stage of matching network, an inductor 505, an inductor 506, a capacitor 507 and an inductor 508 form a second stage of matching network, and an inductor 509, an inductor 510, a capacitor 511 and an inductor 512 form an N^{th} stage of matching network. The inductor 501 and the inductor 502 are connected in parallel to form an LC parallel resonance circuit, and the inductor 502 and the capacitor 503 are connected in series to form an LC series resonance circuit. In the second stage of matching network, ..., and the N^{th} stage of matching network, the inductor 505 and the inductor 506, the capacitor 507 and the inductor 508, the inductor 509 and the inductor 510 as well as the capacitor 511 and the inductor 512 respectively form an LC parallel resonance circuit and an LC series resonance circuit, and the working principle of each stage of matching network has been explained above and will not be described herein.

In the low-pass matching network of the radio frequency power amplifier, one end of the LC parallel resonance circuit of each stage of matching network is respectively connected to one end of the LC series resonance circuit of the same stage of matching network and the LC parallel resonance circuit of the next stage of matching network, and the other end of the LC series resonance circuit of each stage of matching network is grounded. The harmonic wave and spurious in the radio frequency signal amplified by the amplifying unit can be filtered out by means of the low-pass matching network, so as to ensure the stability of the output radio frequency signal. Because each stage of matching network can generate 2 resonance points, the low-pass matching network can generate 2N (N is a positive integer, the same below) resonance points in total. Furthermore, the 2N resonance points can be configured independently of each other, so that a low-pass impedance matching function is realized, and further, the effect of suppressing the harmonic wave and spurious is achieved.

It should be noted that, in order to avoid the condition that the first power source 106 of the radio frequency power amplifier provided by the present invention generates harmonic wave and spurious components under coupling action in a process of supplying a power supply voltage for the control circuit 101, the first power source 106 and the second power source 107 can be connected together, and the first power source 106 and the second power source 107 both connect with the harmonic suppression unit 108, thereby realizing suppression of the harmonic wave and spurious components generated in the power supply processes of the first power source 106 and the second power source 107. Accordingly, another embodiment of the radio frequency power amplifier shown in FIG. 6 is provided. In this embodiment, a harmonic suppression unit 608 (namely the harmonic suppression unit 108 in FIG. 1) realizes suppression of the harmonic wave and spurious in a first power source 606 (namely the first power source 106 in FIG. 1) and a second power source 607 (namely the second power source 107 in FIG. 1), and respectively supplies power supply voltages for a control circuit 601 and an LDO circuit 603, so that a control voltage 602 generated by the control circuit can control the LDO circuit 603 to output different voltages 604. A spurious suppression unit 605 realizes effective suppression of the spurious generated by the voltages 604, and supplies a stable interference-free power supply voltage for the amplifying unit. A radio frequency signal is amplified by means of the amplifying unit (including a first stage of amplifying circuit 611 to an N^{th} stage of amplifying circuit 612), the harmonic wave and spurious are filtered out by means of a low-pass matching network 614, and finally, the amplified radio frequency signal is output to a load (antenna). Compared with the structure of the radio frequency power amplifier in FIG. 1, only a first power source 606 and a second power source 607 are connected together in the structure of the radio frequency power amplifier in FIG. 6, so that the structure and principle of the radio frequency power amplifier are not described in detail.

According to the radio frequency power amplifier provided by the present invention, on the one hand, the first power source and the second power source both connect with the harmonic suppression unit, and the harmonic wave suppression unit adopts the LC array, thereby realizing suppression of the harmonic wave and spurious of the first power source and the second power source at the resonance frequency. A plurality of loads including load inductors and LC arrays are adopted, all stages of loads are connected in cascade by means of isolation inductors to form the spurious suppression unit, and the spurious suppression unit is utilized for suppressing spurious of the amplifying unit. On the other hand, the low-pass matching network is embedded in the output end of the radio frequency power amplifier, thereby realizing suppression of the harmonic wave and spurious of the radio frequency signal amplified by the amplifying unit at different frequencies. Simultaneously, the radio frequency power amplifier realizes effective suppression of the harmonic wave and spurious by connecting the LC array to the power source path and using the low-pass matching network, the design complexity of the radio frequency power amplifier is simplified, and the cost for realizing the related design is lowered.

The radio frequency power amplifier capable of suppressing harmonic wave and spurious can be applied to a chip. The specific structure and connection modes of the radio frequency power amplifier used in the chip are not specifically described herein.

In addition, the radio frequency power amplifier capable of suppressing harmonic wave and spurious provided by the present invention can also be applied to a communication terminal to serve as an important component of a radio frequency circuit. The communication terminal refers to computer device which can be used in a mobile environment and supports multiple communication systems such as GSM, EDGE, TD_SCDMA, TDD_LTE and FDD_LTE, and the computer device includes but not limited to a mobile phone, a notebook computer, a tablet computer, an on-board computer or the like. In addition, the radio frequency power amplifier is also suitable for other multi-mode technical application occasions, such as communication base stations compatible with various communication systems. The occasions are not described one by one in detail herein.

The radio frequency power amplifier for suppressing harmonic wave and spurious, the chip, and the communication terminal provided in the embodiments of the present invention are described in detail above. For a person of ordinary skill in the art, any obvious modification made to the present invention without departing from essence of the present invention will fall within the protection range of the claims of the present invention.

## Claims

1. A radio frequency power amplifier for suppressing harmonic wave and spurious, comprising a control circuit (101), a first power source (106), a second power source (107), a harmonic suppression unit (108), an amplifying unit and a low-pass matching network (114), the low-pass matching network (114) is arranged at an output end of the amplifying unit, **characterized in that**:
the radio frequency power amplifier further comprises an LDO circuit (103) that is connected to the control circuit (101) and a spurious suppression unit (105), the first power source (106) is connected to the control circuit (101), the second power source (107) is connected to the LDO circuit (103),
one end of the harmonic suppression unit (108) is connected to the second power source (107), and the other end of the harmonic suppression unit (108) is grounded, and
the spurious suppression unit (105) is arranged between the LDO circuit (103) and the amplifying unit, wherein the amplifying unit is a multi-stage amplifying circuit and composed of N amplifying circuits in cascade, N is a positive integer, the spurious suppression unit (105) is composed of N loads in cascade, and each stage of load is connected to the next stage of load by means of an isolation inductor (307); each stage of load comprises a load inductor (309) and an LC array (308), one end of the LC array (308) is respectively connected to the load inductor (309) and the isolation inductor (307), and the other end of the LC array (308) is grounded; the other end of the isolation inductor (307) is connected to the next stage of load, the other end of the load inductor (309) is connected to a collector electrode or a drain electrode of a corresponding transistor (312) in the corresponding amplifying circuit, and an emitter electrode or a source electrode of the transistor (312) is grounded.

2. The radio frequency power amplifier according to claim 1, wherein
the harmonic suppression unit (108) is an LC array which comprises a plurality of LC series resonance circuits connected in parallel, and each LC series resonance circuit comprises a capacitor and an inductor connected in series.

3. The radio frequency power amplifier according to claim 1, wherein
the low-pass matching network (114) is a multi-stage matching network which comprises a plurality of matching networks in cascade, and each of the matching networks comprises a first inductor, a first capacitor, a second inductor and a second capacitor;
the first inductor and the first capacitor are connected in parallel to form an LC parallel resonance circuit, and the second inductor and the second capacitor are connected in series to form an LC series resonance circuit; and
one end of the LC series resonance circuit is connected to the LC parallel resonance circuit, and the other end of the LC series resonance circuit is grounded, the LC series resonance circuits is connected to the LC parallel resonance circuit which are of the same matching network.

4. The radio frequency power amplifier according to claim 3, wherein
in each stage of the matching network, the resonance frequency of the LC parallel resonance circuit is higher than working frequency of the radio frequency power amplifier, the resonance frequency of the LC series resonance circuit is higher than the working frequency.

5. The radio frequency power amplifier according to claim 1, wherein
the amplifying unit comprises at least two amplifying circuits in cascade;
each of the amplifying circuits comprises a transistor, and the amplifying circuits are connected by means of capacitors; and
The amplifying circuits are respectively connected to the spurious suppression unit (105).

6. A chip, comprising the radio frequency power amplifier according to any one of claims 1-5.

7. A communication terminal, comprising the radio frequency power amplifier according to any one of claims 1-5.

## Patentansprüche

1. Radiofrequenz-Leistungsverstärker zur Unterdrückung von Oberwellen und Störsignalen, umfassend eine Steuerschaltung (101), eine erste Stromversorgung (106), eine zweite Stromversorgung (107), eine Oberwellen-Unterdrückungseinheit (108), eine Verstärkereinheit und ein Tiefpass-Anpassungsnetzwerk (114), wobei das Tiefpass-Anpassungsnetzwerk (114) an einem Ausgangsende der Verstärkereinheit angeordnet ist,
**dadurch gekennzeichnet, dass**:
der Radiofrequenz-Leistungsverstärker ferner eine LDO-Schaltung (103), die mit der Steuerschaltung (101) und einer Störunterdrückungseinheit (105) verbunden ist, umfasst, die erste Stromversorgung (106) mit der Steuerschaltung (101) verbunden ist, die zweite Stromversorgung (107) mit der LDO-Schaltung (103) verbunden ist,
ein Ende der Oberwellen-Unterdrückungseinheit (108) mit der zweiten Stromversorgung (107) verbunden ist und das andere Ende der Oberwellen-Unterdrückungseinheit (108) mit Masse verbunden ist, und
die Störunterdrückungseinheit (105) zwischen der LDO-Schaltung (103) und der Verstärkereinheit angeordnet ist, wobei die Verstärkereinheit eine mehrstufige Verstärkerschaltung ist und aus N in Kaskade geschalteten Verstärkerschaltungen besteht, N eine positive ganze Zahl ist, die Störunterdrückungseinheit (105) aus N in Kaskade geschalteten Lasten besteht und jede Laststufe mit der nächsten Laststufe über eine Isolationsinduktivität (307) verbunden ist; jede Laststufe eine Lastinduktivität (309) und ein LC-Array (308) umfasst, wobei ein Ende des LC-Arrays (308) mit der Lastinduktivität (309) und der Isolationsinduktivität (307) verbunden ist und das andere Ende des LC-Arrays (308) mit Masse verbunden ist; das andere Ende der Isolationsinduktivität (307) mit der nächsten Laststufe verbunden ist, das andere Ende der Lastinduktivität (309) mit einer KollektorElektrode oder einer Drain-Elektrode eines entsprechenden Transistors (312) in der entsprechenden Verstärkerschaltung verbunden ist und eine Emitter-Elektrode oder eine Source-Elektrode des Transistors (312) mit Masse verbunden ist.

2. Radiofrequenz-Leistungsverstärker nach Anspruch 1, wobei
die Oberwellen-Unterdrückungseinheit (108) ein LC-Array ist, das eine Vielzahl von parallel geschalteten LC-Serienresonanzschaltungen umfasst, und jede LC-Serienresonanzschaltung einen in Reihe geschalteten Kondensator und eine Induktivität umfasst.

3. Radiofrequenz-Leistungsverstärker nach Anspruch 1, wobei
das Tiefpass-Anpassungsnetzwerk (114) ein mehrstufiges Anpassungsnetzwerk ist, das eine Vielzahl von in Kaskade geschalteten Anpassungsnetzwerken umfasst, und jedes der Anpassungsnetzwerke eine erste Induktivität, einen ersten Kondensator, eine zweite Induktivität und einen zweiten Kondensator umfasst;
die erste Induktivität und der erste Kondensator parallel geschaltet sind, um eine LC-Parallelresonanzschaltung zu bilden, und die zweite Induktivität und der zweite Kondensator in Reihe geschaltet sind, um eine LC-Serienresonanzschaltung zu bilden; und
ein Ende der LC-Serienresonanzschaltung mit der LC-Parallelresonanzschaltung verbunden ist und das andere Ende der LC-Serienresonanzschaltung mit Masse verbunden ist, wobei die LC-Serienresonanzschaltung mit der LC-Parallelresonanzschaltung desselben Anpassungsnetzwerks verbunden ist.

4. Radiofrequenz-Leistungsverstärker nach Anspruch 3, wobei
in jeder Stufe des Anpassungsnetzwerks die Resonanzfrequenz der LC-Parallelresonanzschaltung höher als die Betriebsfrequenz des Radiofrequenz-Leistungsverstärkers ist und die Resonanzfrequenz der LC-Serienresonanzschaltung höher als die Betriebsfrequenz ist.

5. Radiofrequenz-Leistungsverstärker nach Anspruch 1, wobei
die Verstärkereinheit mindestens zwei in Kaskade geschaltete Verstärkerschaltungen umfasst;
jede der Verstärkerschaltungen einen Transistor umfasst und die Verstärkerschaltungen über Kondensatoren verbunden sind; und
die Verstärkerschaltungen jeweils mit der Störunterdrückungseinheit (105) verbunden sind.

6. Chip, umfassend den Radiofrequenz-Leistungsverstärker nach einem der Ansprüche 1 bis 5.

7. Kommunikationsendgerät, umfassend den Radiofrequenz-Leistungsverstärker nach einem der Ansprüche 1 bis 5.

## Revendications

1. Amplificateur de puissance radiofréquence destiné à supprimer des harmoniques et des parasites, comprenant un circuit de commande (101), une première source d'alimentation (106), une deuxième source d'alimentation (107), une unité de suppression d'harmoniques (108), une unité d'amplification et un réseau d'adaptation passe-bas (114), le réseau d'adaptation passe-bas (114) étant disposé à une extrémité de sortie de l'unité d'amplification,
**caractérisé en ce que** :
l'amplificateur de puissance radiofréquence comprend en outre un circuit LDO (103) qui est connecté au circuit de commande (101) et à une unité de suppression des parasites (105), la première source d'alimentation (106) est connectée au circuit de commande (101), la deuxième source d'alimentation (107) est connectée au circuit LDO (103),
une extrémité de l'unité de suppression d'harmoniques (108) est connectée à la deuxième source d'alimentation (107), et l'autre extrémité de l'unité de suppression d'harmoniques (108) est connectée à la masse, et
l'unité de suppression des parasites (105) est disposée entre le circuit LDO (103) et l'unité d'amplification, dans lequel l'unité d'amplification est un circuit amplificateur à plusieurs étages et est constituée de N circuits amplificateurs en cascade, N est un entier positif, l'unité de suppression des parasites (105) est constituée de N charges en cascade, et chaque étage de charge est connecté à l'étage de charge suivant au moyen d'une inductance d'isolation (307) ; chaque étage de charge comprend une inductance de charge (309) et un réseau LC (308), une extrémité du réseau LC (308) est connectée à l'inductance de charge (309) et à l'inductance d'isolation (307), et l'autre extrémité du réseau LC (308) est connectée à la masse ; l'autre extrémité de l'inductance d'isolation (307) est connectée à l'étage de charge suivant, l'autre extrémité de l'inductance de charge (309) est connectée à une électrode de collecteur ou à une électrode de drain d'un transistor correspondant (312) dans le circuit amplificateur correspondant, et une électrode d'émetteur ou une électrode de source du transistor (312) est connectée à la masse.

2. Amplificateur de puissance radiofréquence selon la revendication 1, dans lequel l'unité de suppression d'harmoniques (108) est un réseau LC qui comprend une pluralité de circuits résonants série LC connectés en parallèle, et chaque circuit résonant série LC comprend un condensateur et une inductance connectés en série.

3. Amplificateur de puissance radiofréquence selon la revendication 1, dans lequel
le réseau d'adaptation passe-bas (114) est un réseau d'adaptation à plusieurs étages qui comprend une pluralité de réseaux d'adaptation en cascade, et chacun des réseaux d'adaptation comprend une première inductance, un premier condensateur, une deuxième inductance et un deuxième condensateur ;
la première inductance et le premier condensateur sont connectés en parallèle pour former un circuit résonant parallèle LC, et la deuxième inductance et le deuxième condensateur sont connectés en série pour former un circuit résonant série LC ; et
une extrémité du circuit résonant série LC est connectée au circuit résonant parallèle LC, et l'autre extrémité du circuit résonant série LC est connectée à la masse, le circuit résonant série LC est connecté au circuit résonant parallèle LC du même réseau d'adaptation.

4. Amplificateur de puissance radiofréquence selon la revendication 3, dans lequel
dans chaque étage du réseau d'adaptation, la fréquence de résonance du circuit résonant parallèle LC est supérieure à la fréquence de fonctionnement de l'amplificateur de puissance radiofréquence, et la fréquence de résonance du circuit résonant série LC est supérieure à la fréquence de fonctionnement.

5. Amplificateur de puissance radiofréquence selon la revendication 1, dans lequel
l'unité d'amplification comprend au moins deux circuits amplificateurs en cascade ;
chacun des circuits amplificateurs comprend un transistor, et les circuits amplificateurs sont connectés au moyen de condensateurs ; et
les circuits amplificateurs sont respectivement connectés à l'unité de suppression des parasites (105).

6. Puce, comprenant l'amplificateur de puissance radiofréquence selon l'une quelconque des revendications 1 à 5.

7. Terminal de communication, comprenant l'amplificateur de puissance radiofréquence selon l'une quelconque des revendications 1 à 5.
